**Europäisches Patentamt**

**European Patent Office**

**Office européen des brevets**

(19)

(11) **EP 1 143 034 A1**

(12) **EUROPÄISCHE PATENTANMELDUNG**

(43) Veröffentlichungstag:
**10.10.2001 Patentblatt 2001/41**

(51) Int Cl.⁷: **C23C 16/44**, C23C 16/455, C30B 25/14

(21) Anmeldenummer: **01108251.8**

(22) Anmeldetag: **31.03.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **06.04.2000 DE 10016971**

(71) Anmelder: **Angewandte Solarenergie - ASE GmbH**
**63755 Alzenau (DE)**

(72) Erfinder:
 • **v. Campe, Hilmar, Dr.**
   **61352 Bad Homburg (DE)**

 • **Nikl, Dieter, Dr.**
   **65779 Kelkheim (DE)**
 • **Ebinger, Horst**
   **63628 Salmünster (DE)**
 • **Will, Stephan, Dr.**
   **35578 Wetzlar (DE)**
 • **Buschbaum, Torsten**
   **7320 Sargans (CH)**

(74) Vertreter:
**Stoffregen, Hans-Herbert, Dr. Dipl.-Phys.**
**Patentanwalt,**
**Friedrich-Ebert-Anlage 11b**
**63450 Hanau (DE)**

(54) **Verfahren und Vorrichtung zum Beschichten und/oder Behandeln eines Substrates**

(57) Die Erfindung bezieht sich auf ein Verfahren und eine Vorrichtung zum Beschichten und/oder Behandeln einer Fläche eines Substrats durch Beaufschlagen dieser mit einem Gas mit für die Beschichtung erforderlichen schichtbildenden Teilchen, die auf der Fläche abgeschieden werden und/oder mit dieser reagieren. Um Substratflächen in gewünschtem Umfang zu beschichten bzw. durch Reaktion mit Gasen zu behandeln, wobei insbesondere CVD-Verfahren zur Anwendung gelangen sollen, wird vorgeschlagen, dass das Gas in Teilströme (76) aufgeteilt wird, die in Bezug auf ihre Teilchenkonzentration und/oder Verweildauer auf der Fläche bzw. in unmittelbarer Nähe der Fläche des Substrats (32) derart eingestellt werden, dass pro Flächeneinheit pro Zeiteinheit gleiche Mengen an Teilchen abgeschieden werden und/oder reagieren.

Fig. 3

EP 1 143 034 A1

**Beschreibung**

Die Erfindung bezieht sich auf ein Verfahren zum Beschichten einer Fläche eines Substrates durch Beaufschlagen dieser mit einem Gas mit für die Beschichtung erforderlichen schichtbildenden Teilchen, die auf der Fläche abgeschieden werden und/oder mit dieser reagieren. Ferner bezieht sich die Erfindung auf eine Vorrichtung zum Beschichten und/oder Behandeln einer Fläche eines Substrates durch Beaufschlagen dieser mit einem Gas, umfassend mehrere gasabgebende Quellen sowie mit dem Substrat reagiertes bzw. dieses beaufschlagtes Gas abführende Senken.

Um Substrate bzw. Flächen dieser im CVD-Verfahren (Chemical Vapor Deposition) zu beschichten, können unterschiedliche Prinzipien zur Anwendung gelangen. So besteht die Möglichkeit, einen Gasfluss parallel zur Substratoberfläche zu führen. Dabei kann das Substrat feststehend oder bewegt sein. Durch die Gasführung entlang der Substratoberfläche ist die Tendenz zur schnellen Verarmung des Trägergases gegeben. Dabei sind bei feststehendem Substrat inhomogene Abscheideraten, inhomogene Schichtdicken sowie ungleichmäßige Dotierungen in Richtung der Schichtdicke und in der Schichtfläche festzustellen.

Beim bewegten Substrat ist zwar eine homogene Schichtdicke erzielbar, jedoch die Abscheiderate ist inhomogen. Auch ist eine ungleichmäßige Dotierung in Richtung der Schichtdicke festzustellen.

In Stauflussreaktoren strömt das einer Substratoberfläche zuzuführende Gas senkrecht von oben auf die zu beschichtende Fläche. Bei nicht sehr großen Substratflächen kann dabei eine homogene Abscheiderate erzielt werden. Auch hinsichtlich der Schichtdicke und der Dotierung in Richtung der Schichtdicke und in der Schichtfläche ist eine Homogenität festzustellen. Allerdings bereitet des Rückführen von reagiertem Gas bei Beschichtung großer Flächen Probleme, so dass bei Stauflussreaktoren gute Ergebnisse nur bei relativ kleinen Substratflächen erzielbar sind.

Um großflächige homogene Abscheidungen zu erzielen, werden Pancake-Reaktoren benutzt, die dem Prinzip des Stauflussreaktors ähnlich sind. Dies bedeutet, dass die zu beschichtende Fläche senkrecht angeströmt wird. Das Substrat selbst ist auf einem heißen Suszeptor angeordnet, so dass aufgrund der hierdurch bedingten Konvektion in der Gasatmosphäre eine Durchmischung und Homogenisierung des Gases erzielbar ist. Infolgedessen ergeben sich homogene Abscheideraten, homogene Schichtdicken sowie homogene Dotierungen in Richtung der Schichtdicke und der Schichtfläche. Die Homogenität kann zusätzlich dadurch erhöht werden, dass der Suszeptor beim Beschichten gedreht wird. Auch wenn ein entsprechendes Beschichtungsverfahren für große Flächen geeignet ist und reproduzierbare, hochwertige Epitaxieschichten ergibt, muss als nachteilig angesehen werden, dass die Gaszuführung aus der Mitte des Systems durch eine Scheibe erfolgt und daher in der Anwendung auf die Wafer-Beschichtung beschränkt bleibt.

Entsprechende Verfahren bzw. zum Einsatz gelangende Reaktoren sind der Literaturstelle US-Z: Chemical Vapor Deposition for Microelectronics, Arthur Sherman, Noyes Publications, USA, S. 31- 39, 150 - 174 zu entnehmen.

Der Erfindung liegt das Problem zu Grunde, ein Verfahren und eine Vorrichtung der eingangs genannten Art so weiterzubilden, dass Substratflächen in gewünschtem Umfang beschichtbar bzw. durch Reaktion mit Gasen behandelbar sind, wobei insbesondere CVD-Verfahren zur Anwendung gelangen sollen. Ferner soll die Möglichkeit einer großtechnischen Behandlung bzw. Beschichtung von Flächen möglich sein.

Erfindungsgemäß wird das Problem durch ein Verfahren der eingangs genannten Art dadurch gelöst, dass das Gas in Teilströme aufgeteilt wird, die in Bezug auf ihre Teilchenkonzentration und/oder Verweildauer unmittelbar im Gebiet der Fläche und/oder auf der Fläche des Substrates derart eingestellt werden, dass pro Flächeneinheit pro Zeiteinheit gleiche Mengen an Bestandteilen abgeschieden werden und/oder reagieren. Dabei kann die Verweildauer durch Relativbewegung bzw. -geschwindigkeit zwischen Substrat und die Teilströme abgebenden Quellen eingestellt werden. Insbesondere werden die Gasteilströme über mehrere Quellen an die Fläche abgegeben, zwischen denen sich Senken für mit der Fläche reagiertes und/oder das Substrat beaufschlagtes Gas befinden. Unmittelbar im Gebiet der Fläche bedeutet dabei der Raum zwischen Austritt der Gasteilströme aus den Quellen und der bzw. den zu beaufschlagenden Flächen.

Die Teilströme selbst beaufschlagen senkrecht aufsteigend die Fläche, wobei die Quellen und/ oder die Senken gleichmäßig über die Fläche unterhalb dieser angeordnet werden. Erforderliche Erwärmung der Substrate und damit der zu beschichtenden bzw. zu behandelnden Fläche erfolgt insbesondere von gasabgewandter Fläche des Substrats.

Bei der Behandlung bzw. Beschichtung der Fläche selbst sollte das Substrat senkrecht zur Gasströmung bewegt werden, wodurch ein kontinuierlich arbeitendes Durchlaufverfahren ermöglicht wird, das insbesondere für großflächige Substrate und somit für große Flächen geeignet ist. Dadurch, dass die Senken gleichmäßig sowohl unterhalb der zu beschichtenden bzw. zu behandelnden Fläche als auch zwischen den die Gasteilströme abgebenden Quellen angeordnet sind, ist sichergestellt, dass pro Flächeneinheit und pro Zeiteinheit gleiche Mengen an Bestandteilen aus dem Gas abgeschieden werden und/oder mit der Fläche reagieren, so dass homogene Abscheideraten, homogene Schichtdicken und gleichmäßige also homogene Dotierung sowohl in Richtung der Schichtdicke als auch in der von der Fläche aufgespannten Ebene selbst erzielbar sind. Eine undefinierte Verarmung des die Teilchen zum Reagieren bzw. Behandeln der Fläche enthaltenden Gases, das auch als Träger- oder Nährgas bezeichnet werden kann, erfolgt nicht.

Eine Vorrichtung zum Beschichten und/oder Behandeln einer Fläche eines Substrates, insbesondere durch CVD-Verfahren, umfassend mehrere gasabgebende Quellen sowie mit dem Substrat reagiertes bzw. dieses beaufschlagtes gasabführende Senken zeichnet sich dadurch aus, dass die Fläche des Substrates oberhalb der Quellen und Senken angeordnet ist und dass die Quellen gleichmäßig auf einen Bereich verteilt angeordnet sind, der durch vertikale Projektion der Fläche des Substrates vorgegeben ist, wobei vorzugsweise die Senken gleichmäßig verteilt zwischen den Quellen angeordnet sind. Insbesondere bilden die Quellen und Senken ein Gasverteilungssystem, dessen flächige Erstreckung zumindest gleich oder im Wesentlichen zumindest gleich der Fläche des Substrates selbst ist.

Die das Träger- bzw. Nährgas abgebenden Quellen können als Schlitze, Düsen oder sonstige Öffnungen ausgebildet sein bzw. solche aufweisen, über die das Gas senkrecht oder im Wesentlichen senkrecht aufsteigend auf die Fläche des Substrats abgebbar ist.

Dabei können Quellen in einer ersten parallel zu der Fläche verlaufenden Ebene angeordnet und die Senken in einer zweiten parallel zu der Fläche verlaufenden Ebene angeordnet sein, wobei erste und zweite Ebene beabstandet sein können. Bevorzugterweise sollte bei einer entsprechenden Ausbildung die die Quellen umfassende erste Ebene flächennäher als die zweite die Senken umfassende Ebene verlaufen.

In Weiterbildung der Erfindung ist vorgesehen, dass die Quellen wie Öffnungen, Schlitze oder Düsen von einem homogen verteiltes Gas enthaltenden Raum ausgehen. Bei dem Raum selbst kann es sich zum Beispiel um einen quaderförmigen Raum oder um einen Hohlzylinder wie Rohr handeln. Auch sind unter "Raum" auch mehrere Hohlzylinder oder Rohre zu verstehen.

Bei der Verwendung von Rohren sollten diese parallel zueinander unterhalb der Fläche des Substrats angeordnet sein, wobei die Quellen wie Austrittsöffnungen, insbesondere Schlitze entlang jeweiliger Längsachse der Rohre angeordnet sind. Schlitzlängsachsen und Längsachse des Rohres verlaufen demnach parallel.

Das Gasverteilungssystem selbst kann innerhalb eines Reaktionsraums angeordnet sein, der von der Fläche des Substrates verschließbar bzw. begrenzt ist. Dabei ist insbesondere vorgesehen, dass das Substrat über Führungen auf den Reaktionsraum ausrichtbar ist, wobei dieser über das Substrat und die Führungen abdichtbar ist.

Erforderliche Wärmequellen wie zum Beispiel Strahlungsheizung und/oder Mikrowellenstrahler können oberhalb des Substrats auf dessen gasverteilungssystemabgewandter Fläche angeordnet sein.

Insbesondere ist auch vorgesehen, dass die Reaktionsräume selbst von einer Kammer aufgenommen sind, um die Fläche des Substrates nacheinander zu behandeln bzw. zu beschichten, wobei Reaktionsräume mit unterschiedlichen Nähr- bzw. Trägergasen beaufschlagbar sein können. Die Kammeranlage stellt eine Durchlaufanlage dar, wobei die in dieser vorhandenen Reaktionsräume zur sukzessiven Beschichtung bzw. Behandlung der Fläche nacheinander mit dem Substrat bzw. der Fläche verschließbar sind. Die Kammeranlage kann von einem Inertgas durchströmbar sein, dessen Strömungsrichtung entgegengesetzt zur Förderrichtung des Substrates verläuft.

Weitere Einzelheiten, Merkmale und Vorteile der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:

Fig. 1 eine erste Anordnung zum Beschichten eines Substrates,

Fig. 2 einen Ausschnitt einer zweiten Ausführungsform einer Anordnung zum Beschichten eines Substrates,

Fig. 3 eine Prinzipdarstellung einer dritten Ausführungsform einer Anordnung zum Beschichten eines Substrates und

Fig. 4 eine Prinzipdarstellung einer Durchlaufanlage.

Um Substrate wie solche von Halbleiterbauelementen wie Dünnschichtsolarzellen mit gewünschten Schichten zu versehen bzw. entsprechende auf dem Substrat auszubilden, werden üblicherweise CVD-Abscheideprozesse durchgeführt. Hierzu wird das Substrat mit einem Träger- bzw. Nährgas beaufschlagt, das schichtbildende Teilchen enthält, die auf der Fläche abgeschieden werden bzw. mit dieser reagieren. Erfindungsgemäß ist nun vorgesehen, dass das Nähr- bzw. Trägergas in Teilströme derart aufgeteilt wird, dass in Bezug auf deren Teilchenkonzentration und/oder Verweildauer auf der Fläche pro Flächeneinheit und Zeiteinheit gleiche Mengen an Teilchen abgeschieden werden und/oder reagieren. Um dieses zu realisieren, sind verschiedene Möglichkeiten geben.

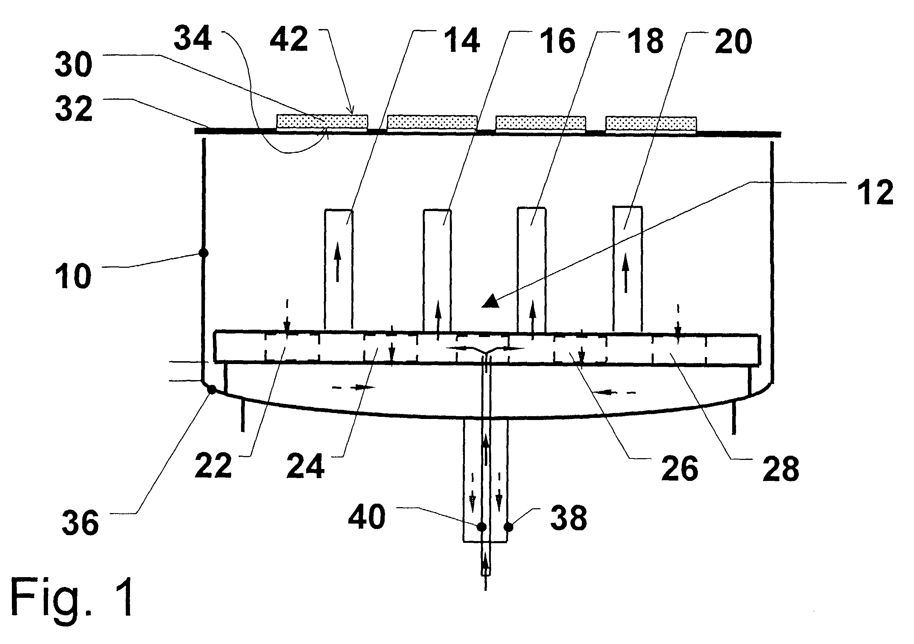

So ist in Fig. 1 prinzipiell eine Vorrichtung mit einem Reaktor 10 dargestellt, in dem ein Gasverteilungssystem 12 angeordnet, die Gasquellen 14, 16, 18, 20 sowie Gassenken 22, 24, 26, 28 umfasst. Die Gasquellen 14, 16, 18, 20, über die das Nähr- bzw. Trägergas in Teilströme aufgeteilt wird, sind im Ausführungsbeispiel nach der Fig. 1 als Schlote oder hohlzylindrische Elemente ausgebildet, die mit ihren Öffnungen unterhalb zu beschichtender Substrate 30 angeordnet sind, die ihrerseits oberhalb des Reaktors 10 angeordnet sind, der über eine Maske 32 mit einer Öffnung oder mehreren Öffnungen abgeschlossen ist, auf die im Ausführungsbeispiel mehrere aneinandergereihte Substrate 30 mit ihren zu beschichtenden Flächen 34 ausgerichtet sind.

Die Gasquellen 14, 16, 18, 20 sind mit ihren Öffnungen gleichmäßig über die von den Substraten 30 aufgespannten Flächen 34 verteilt und verlaufen in einer Ebene, die flächennäher als die Gassenken 22, 24, 26, 28 mit ihren Absaugöffnungen verläuft. Über die Senken 22, 24, 26, 28 wird mit den Flächen 34 reagiertes Gas abgesaugt. Dabei sind die Senken 22, 24, 26, 28 ebenfalls gleichmäßig über die von den Substratflächen 34 aufgespannte Ebene verteilt. Vom Boden 36 des Reaktors 10 geht ein Absaugstutzen 38 für reagiertes Gas aus, innerhalb dessen eine Gaszuführungsleitung 40 verläuft, über die die als Schlote oder Hohlzylinder ausgebildeten Gasquellen 14, 16, 18, 20 mit Träger- bzw. Nährgas versorgt werden.

Dadurch, dass das Gas gleichmäßig über die von den zu beschichtenden Flächen 34 aufgespannte Ebene verteilt und entsprechend auch die reagiertes Gas absaugenden Senken 22, 24, 26, 28 über die Ebene und zwischen den Quellen 14, 16, 18, 20 verteilt sind und das Gas selbst senkrecht aufsteigend die Flächen 34 der Substrate 30 beaufschlagt, ist eine homogene Abscheidung bei gleichzeitiger homogener Schichtdicke und homogener Dotierung sowohl in Richtung der Schichtdicke als auch in der von der Fläche 34 aufgespannten Ebene sichergestellt.

Sofern für den Beschichtungsprozess eine Erwärmung der Flächen 34 erforderlich ist, werden die Substrate 30 von ihrer den Gasquellen 14, 16, 18, 20 abgewandten Fläche 42 zum Beispiel mit Wärmestrahlung oder Mikrowellen beaufschlagt. Dadurch, dass die Gasquellen 14, 16, 18, 20 und damit die Gaszuführung gleichmäßig über die von den Flächen 34 aufgespannte Ebene verteilt sind und das Gas senkrecht aufsteigend auf die Flächen 34 appliziert wird, wobei die von den Gasquellen 14, 16, 18, 20 und den Senken 22, 24, 26, 28 aufgespannte Fläche gleich oder größer als die von den insgesamt zu beschichtenden Flächen 34 ist, ergibt sich eine homogene Gasverteilung, die die reproduzierbare und gewünschte homogene Abscheidung und damit Schichtdicke und Dotierung sicherstellt. Dabei können zusätzlich die Substrate 30 senkrecht zur Gasstromrichtung bewegt werden, um eine weitergehende Verbesserung der Homogenität zu erzielen.

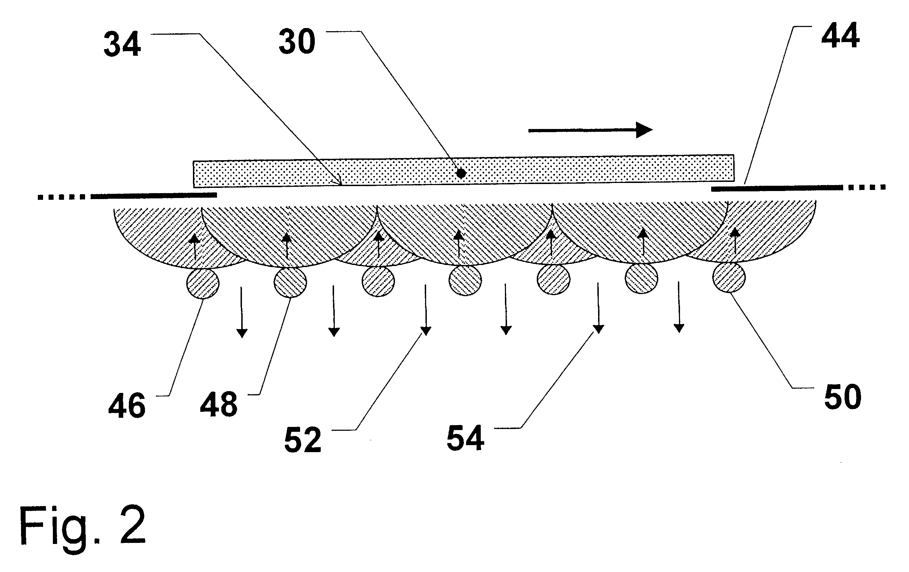

In Fig. 2 ist ein Ausschnitt einer weiteren Ausführungsform einer Anordnung zum Beschichten einer Fläche 34 eines Substrates 30 dargestellt, das entlang einer Öffnung 44 eines nicht dargestellten Reaktors bewegbar ist. In dem Reaktor selbst befinden sich parallel zueinander angeordnete Gasverteilerrohre 46, 48, 50, zwischen denen mit der Fläche 34 reagiertes Gas abgesaugt wird (Pfeile 52, 54). Durch diese Anordnung ist ebenfalls eine gleichmäßige Verteilung der durch die Gasverteilerrohre 46, 48, 50 und den Absaugungen 52, 54 gebildeten Gasquellen und Senken über der Fläche 34 des Substrates 30 gegeben, wodurch die gewünschte Homogenität des auf die Fläche 34 auftreffenden Gasstrahles und damit eine homogene Abscheiderate, Schichtdicke und Dotierung sichergestellt ist. Die Gasverteilerrohre 46, 48, 50 weisen entlang ihrer Längsachse verlaufende Austrittsöffnungen wie Schlitze oder Löcher auf, über die die Gasteilströme auf die Fläche 34 des Substrates 30 abgegeben werden.

Bevorzugterweise werden entlang der Rohre 46, 48, 50, also parallel zu deren Längsachsen verlaufende Schlitze gewählt.

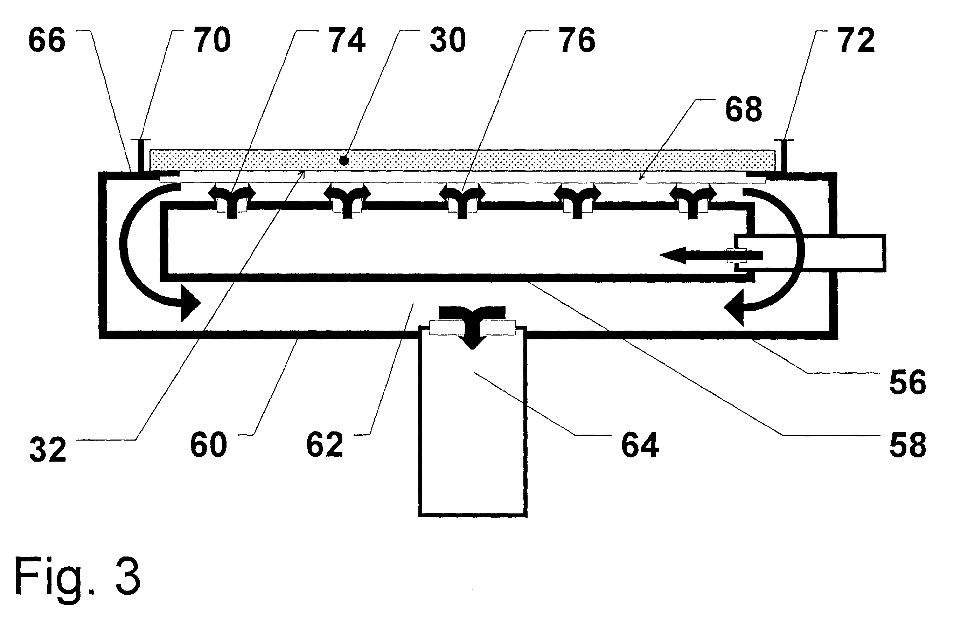

Bei dem Ausführungsbeispiel der Fig. 3 ist ein Reaktor 56 vorgesehen, in dem ein Gasverteilersystem angeordnet ist, das eine Gaszuführung 58 und eine Gasabsaugung 60 aufweist, das die Gaszuführung 58 umfangsseitig in Form eines Ringspaltes 62 umgeht, der seinerseits in einen Gasaustrittsstutzen 64 im Bodenbereich des Reaktors 56 übergeht. In der oberen Wandung 66 des Reaktors 56 ist eine Öffnung 68 vorhanden mit randseitig verlaufenden Führungen 70, 72, entlang der das zu beschichtende Substrat 30 gleitend bzw. auf einem Gaskissen gleitend und im Abstand über den Öffnungen geführt wird. Der Abstand kann z.B. 1 mm bis 20 mm, insbesondere bis 10 mm betragen, ohne dass hierdurch eine Beschränkung der Erfindung erfolgt. Das Substrat 30 kann folglich während der Beschichtung relativ zu der Gaszuführung 58 bzw. Quellen bildenden Austrittsöffnungen 74, 76 geführt werden, die gleichmäßig unterhalb der Fläche 32 des Substrats 30 verteilt sind. Zwischen den Austrittsöffnungen 74, 76 und der Fläche 32 bildet sich quasi ein Gaskissen aus, wobei die Mengen des aus den Öffnungen 74, 76 austretenden Gases in Abhängigkeit von der Position der Öffnung 74, 76 derart aufeinander abgestimmt werden, dass die Teilströme in ihrer Teilchenkonzentration bzw. die Verweildauer der Teilströme zur zu beschichtenden Fläche 32 derart eingestellt sind, dass pro Flächeneinheit und Zeiteinheit gleiche Mengen an Teilchen abgeschieden werden bzw. mit der Fläche 32 reagieren.

Durch diese Druckdifferenz erfolgt die gewünschte reproduzierbare homogene Abscheiderate, Schichtdicke und Dotierung. Dabei wird die Homogenität zusätzlich durch eine Relativbewegung des Substrates 30 entlang der Gleitschienen 70, 72 zu den Gasaustrittsöffnungen 74, 76 verbessert. Reagiertes Gas wird seitlich über den Ringspalt 62 abgesaugt und gelangt über den Gasaustritt 64 aus dem Reaktor 56.

Oberhalb des Substrates 30, also über der Fläche 42, kann eine Heizung wie Strahlungsheizung oder Mikrowellenheizung angeordnet sein, um das Substrat zu erwärmen bzw. gewünschte Beschichtungsprozesse durchführen zu können. Außerdem kann der Raum außerhalb des Reaktors 56 mit Inertgas gespült sein.

Der Gasverteiler 58 selbst besteht vorzugsweise aus Quarz.

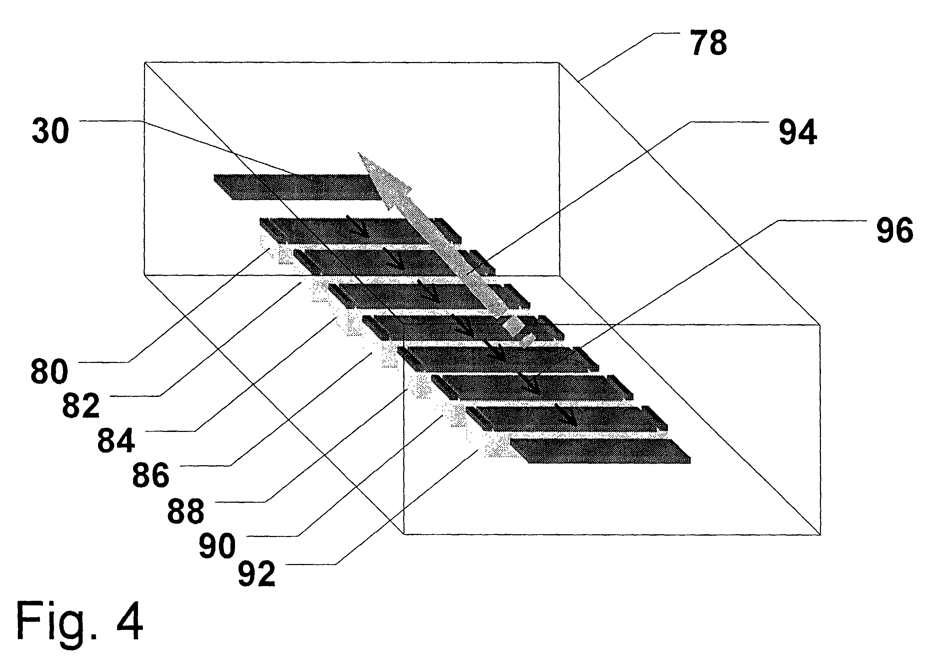

Anhand der Fig. 4 soll verdeutlicht werden, dass das erfindungsgemäße Verfahren auch für ein kontinuierliches Durchlaufverfahren geeignet ist. Hierzu ist eine geschlossene Durchlaufkammer 78 vorgesehen, in der hintereinander mehrere Reaktoren 80, 82, 84, 86, 88, 90, 92 angeordnet sind, die einen der zuvor beschriebenen Aufbauten aufweisen können. Dabei wird jeder Reaktor 80, 82, 84, 86, 88, 90, 92 nacheinander von einem zu beschichtenden Substrat 30 abgedeckt, um die dem Reaktor 80 82. 84, 86, 88, 90. 92 zugewandte Fläche in gewünschtem Umfang zu beschichten. Der Innenraum der Durchlaufkammer 78 selbst kann mit einem Inertgas durchspült sein, wobei die Strömungsrichtung (Pfeil 94) entgegengesetzt zur Transportrichtung (Pfeile 96) des Substrates 30 verlaufen kann.

So kann zum Beispiel ein aus Graphit bestehendes Substrat im ersten Reaktor 80 mit einer SiC-Schicht versehen werden. Im nachfolgenden Reaktor 82 wird auf die SiC-Schicht eine zum Beispiel mit Bor hochdotierte $p^+$-Si-Schicht im CVD-Verfahren abgeschieden. Auf die $p^+$-Si-Keimschicht kann in dem Reaktor 84 eine Capping-Layer aufgetragen werden, um sodann in dem Reaktor 86 eine Rekristallisation durchzuführen. In dem Reaktor 88 wird die Capping-Layer entfernt, um sodann in dem Reaktor 90 eine fotoempfindliche p-Si-Schicht zu epitaxieren, um schließlich in dem Reaktor 92 eine n-leitende Emitterschicht aufzubringen.

Anhand des Ausführungsbeispiels der Fig. 4 soll verdeutlicht werden, dass die erfindungsgemäße Lehre in einem Durchlaufverfahren zur Herstellung zum Beispiel eines kristallinen Si-Dünnschichtsystems anwendbar ist. Dabei wird gewährleistet, dass die auszubildenden Schichten die erforderliche Homogenität, gleichmäßige Dicke und Dotierung aufweisen. Gleichzeitig wird jeder Reaktor 80, 82, 84, 86, 88, 90, 92 selbst während des Prozesses durch das zu behandelnde Substrat 30 abgedeckt.

Bevorzugte Verfahrensparameter ergeben sich aus den nachfolgenden Beispielen:

**Beispiel 1:**

Eine der Fig. 1 entsprechende Vorrichtung wird zur Herstellung einer großflächigen Schicht aus Silicium benutzt. In einem evakuierbaren Kessel, vorzugsweise aus Edelstahl mit wassergekühlten Wänden (Durchmesser ca. 80 cm), befindet sich der Quarzreaktor 36 mit einem Durchmesser von ca. 70 cm. Der Reaktor 36 ist am oberen Ende mit einer Trägerplatte 32 abgeschlossen, die Aussparungen für die Aufnahme von Substraten 42 der Größe 0,1 m x 0,1 m oder eine Aussparung für ein Substrat 30 der Größe 0,4 x 0,4 m besitzt. Das Substrat 30 bzw. 42 wird durch eine transparente Abdeckung des Kessels (z. B. Quarzplatte) mittels eines Lampenfeldes beheizt. Der Raum zwischen Kesselwand und Quarzreaktor wird mit einem chemisch inerten Gas wie Argon oder Stickstoff ständig gespült. Zusätzlich wird aus Sicherheitsgründen dieser Raum mittels eines $H_2$-Sensors überwacht, um sicherzustellen, dass die untere Explosionsgrenze stets unterschritten ist.

Die Heizung erfolgt per optischer bzw. Infrarot-Strahlung eines Strahlerfeldes mit einer Leistungsdichte von 400 kW/m$^2$ bis 700 kW/m$^2$ für Temperaturen von 1100 °C bis 1300 °C. Alternativ erfolgt die Heizung durch Mikrowelleneinstrahlung oder durch induktive Heizung. Die Art der Heizung hängt stark von den Eigenschaften des Substrates ab. Für gut absorbierende (grau bis schwarz gefärbte) Flächen ist die optische Heizung geeignet. Für leitfähige Substrate eignen sich induktive Einkopplung oder die Heizung durch direkten Stromdurchfluss. Für Keramiken mit molekularem Dipolmoment eignet sich die Mikrowellenheizung.

Als Prozessgas wird ein Gasgemisch aus Wasserstoff mit Methyltrichlorsilan (MTCS = $CH_3SiHCl_3$) für die Abscheidung von SiC-Schichten bzw. Trichlorsilan (TCS = $SiHCl_3$) für die Abscheidung von Si-Schichten eingesetzt. Die Dotierung des SiC erfolgt durch Beigabe geringer Mengen Stickstoff (n-leitendes SiC). Silicium kann durch Beigabe geringer Mengen $BCl_3$ für p-leitend dotiert werden.

Gemäß der vereinfachten chemischen Reaktionsgleichung

$$CH_3SiHCl_3 + H_2 \quad \rightarrow SiC + 3\ HCl \qquad (1)$$

$$SiHCl_3 + H_2 \quad \rightarrow Si + 3HCl \qquad (2)$$

$$3\ BCl_3 + 3H_2 \quad \rightarrow 2B + 6HCl \qquad (3)$$

kann die chemische Reaktion bei hoher Temperatur ablaufen.

Die Verteilung des Gasstromes wird über ein Gasverteilungssystem vorzugsweise aus Quarzteilen vorgenommen. Zur Abscheidung von SiC-Schichten wird ein MTCS/$H_2$-Gemisch, zur Abscheidung von Si-Schichten wird ein TCS/$H_2$-Gemisch eingeführt. Das jeweilige Ausgangsgasgemisch wird durch die Gasleitung 40 in das Verteilungssystem eingeleitet. Es gelangt in den Zwischenraum, der durch die beiden Platten 41 und 43 begrenzt wird und strömt über die schlotartigen Rohre 14, 16, 18, 20 gegen die Substrate. Die Substrate befinden sich auf einer Temperatur von 1200 °C bis 1550 °C für die SiC-Abscheidung und von 900 °C bis 1200 °C für die Si-Abscheidung, so dass die chemische Reaktion ausgedrückt durch die Reaktionsgleichungen (1) bis (3) ablaufen kann. Auf dem Substrat 30 bzw. 42 scheidet sich jeweils SiC oder Si ab. Die gasförmigen Produkte werden über die Senken 22, 24, 26, 28 zwischen den beiden Platten 41 und 43 in den unteren Teil des Reaktionsraumes gedrückt, von wo aus diese durch das Rohr 38 abgeführt werden können.

Die Abscheiderate liegt in der Größenordnung 0,1 μm bis 10 μm pro Minute. Sie hängt exponentiell von der Abscheidetemperatur des Substrates und proportional von der Konzentration MTCS bzw. TCS im Prozessgas ab.

Für die Abscheiderate ist das Molverhältnis [Si] : [H] bzw. bei MTCS [C + Si] : [H] ausschlaggebend. Typisch liegt dieses Mol-Verhältnis zwischen 1 : 10 bis 1 : 100. Die Ausbeute liegt je nach Wahl der Parameter bei etwa 10 - 20 %.

Zum Beispiel wird eine 30 μm dicke SiC-Schicht bei einer Temperatur von 1500 °C mit einer Abscheiderate von 5 μm/min auf einer Fläche von 0,16 m$^2$ abgeschieden. Die Gasflüsse sind 130 slm für Wasserstoff, 20 slm für MTCS und 1 slm für Stickstoff als Dotiergas. Das Mol-Verhältnis MTCS : H$_2$ beträgt etwa 1 : 10.

Zum Beispiel wird eine 30 μm dicke Si-Schicht bei einer Temperatur von 1100 °C mit einer Abscheiderate von 5 μm/min auf einer Fläche von 0,16 m$^2$ abgeschieden. Die Gasflüsse sind 200 - 2000 slm für Wasserstoff, 20 slm für TCS und 10 slm für ein Gemisch von BCl$_3$:H$_2$ =1 : 1000 als Dotiergas. Das Mol-Verhältnis TCS : H$_2$ beträgt etwa 1 : 100 bis 1 : 10.

**Beispiel 2:**

Im dem System der Fig. 2 wird das Ausgangsgasgemisch durch parallele Gaspipelines 46, 48, 50 vorzugsweise aus Quarz transportiert, die am oberen Ende Bohrungen aufweisen. Das Gas tritt durch die Bohrungen in den Reaktionsraum ein und trifft auf die beheizte Substratfläche 34. Das Substrat 30 wird parallel zu der durch die Gaspipelines aufgespannte Ebene bewegt. Hierdurch wird die Gleichmäßigkeit der Abscheiderate verbessert. Das Substrat befindet sich auf einer Temperatur von 1200 °C bis 1550 °C im Falle der SiC-Abscheidung und bei Temperaturen von 900 °C bis 1200 °C im Falle der Si-Abscheidung, so dass die chemische Reaktion ausgedrückt durch die Reaktionsgleichungen (1) bzw. (2) ablaufen kann. Auf dem Substrat scheidet sich jeweils SiC oder Si ab. Die gasförmigen Produkte 52 und 54 werden durch Zwischenräume zwischen den Pipelines abgeführt.

In einem Durchlaufsystem der Fig. 2 bis 4 kann über den Vorschub und die Wahl der Streckenlänge der Durchsatz erheblich gesteigert werden. Da Abscheideraten von 5 μm/min bis 10 μm/min mit dem Normaldruck-CVD-Verfahren erreicht werden können, sind nur noch 3 - 6 min für die Abscheidung einer 30 μm dicken CVD-Schicht nötig. Bei Beibehaltung der Dimension 40 cm Breite und Verdopplung der Beschichtungslänge auf 80 cm kann mit der Anordnung der Fig. 2 eine Fläche von 0,32 m$^2$ in 3 bis 6 min im Durchlaufverfahren hergestellt werden.

**Beispiel 3**

Zur Herstellung einer großflächigen Schicht aus Siliciumdioxid (als Deckschicht für den Kristallisationsprozeß bei der Herstellung einer kristallinen Si-Dünnschichtsolarzelle) wird als Prozeßgas ein Gasgemisch aus Monosilan SiH$_4$ und Sauerstoff O$_x$ eingesetzt. Das Gas wird mit Inertgas wie Stickstoff, CO$_2$, Argon oder anderen Edelgasen verdünnt um spontane Keimbildung in der Gasphase und damit Staub zu unterdrücken. Die chemische Reaktion verläuft gemäß der vereinfachten chemischen Reaktionsgleichung

$$SiCl_4 + 2\ H_2O \rightarrow SiO_2 + 4\ HCl$$

bei Temperaturen von ca. 250 bis 800 °C vorzugsweise bei 400 °C bis 450 °C .

Die Verteilung des Gasstromes wird über das Gasverteilungssystem vorzugsweise aus Quarzteilen vorgenommen. Die Abscheiderate liegt in der Größenordnung 0,1 μm bis 0,5 μm pro Minute. Die Beschichtung erfolgt bei Atmospärendruck.

Die Beschichtung kann auch im Unterdruck erfolgen, wobei die Qualität der Oxidschicht noch besser, die Abscheiderate jedoch entsprechend der Teilchenkonzentration kleiner wird.

Um pyrofores SiH$_4$ zu vermeiden, kann als Siliciumquelle stattdessen auch Tetraethylorthosilikat (C$_2$H$_5$O)$_4$Si (TEOS) eingesetzt werden. Der Prozeß wird bei 500 mbar bis 1000 mbar und Temperaturen von 600°C bis 800°C, vorzugsweise 700°C durchgeführt.

**Beispiel 4**

Zur Entfernung der großflächigen Schicht aus Siliciumdioxid (nach erfolgter Kristallisation) wird die Oberfläche auf Temperaturen zwischen 1150°C und 1300°C erhitzt und in reinem Wasserstoff reduziert. Vorzugsweise eignet sich eine Temperatur von 1200°C. Nach vollständiger Entfernung der Oxidschicht liegt die kristallisierte Siliciumschicht als Keimschicht frei und darauf kann die Si-Halbleiterschicht epitaxiert werden.

Als Alternative zur Oxid-Entfernung durch Reduktion mit Wasserstoff wird ein H$_2$O/HF-Gemisch bei Temperaturen von Raumtemperatur bis 300 °C, vorzugsweise 50 °C - 100 °C (jeweils Substrattemperatur) etwa 100 °C - 300 °C über die mit Oxid bedeckte Probe geleitet. Es findet eine chemische Reaktion der Art

$$SiO_2 + 4\ HF + H_2O \rightarrow \quad SiF_4 + 3\ H_2O$$

statt. Die Verbindungen SiF$_4$ und H$_2$O sind flüchtig und verdampfen bei diesen Temperaturen. Somit läßt sich auch bei niedrigen Temperaturen aus der Gasphase ein Ätzeffekt erzielen, so daß die 2 μm dicke Oxidschicht in ca 10 min verdampft.

**Beispiel 5:**

Es wird das Ausgangsgasgemisch durch ein Rohr in das Innenvolumen 58 eines an der dem Substrat 30 zugewandten Seite ebenen Gastransportkammer geleitet. Das Gas kann durch Bohrungen 74, 76 austreten und trifft gegen die beheizte Substratoberfläche 32. Durch den Zwischenraum 68 zwischen der Austrittsebene und dem Substrat können die gasförmigen Produkte nach rechts und links abgeführt werden. Das Gas wird um die Gastransportkammer herum geleitet und nach unten durch eine Ableitung 90 mit großem Querschnitt aus dem Reaktionsraum herausgedrückt.

Mehrere dieser Reaktionskammern können hintereinander geschaltet werden, so dass sich hieraus ein Durchlaufsystem entwickelt, mit dem alle Schichten verschiedener Zusammensetzung nacheinander abgeschieden werden können. In Fig. 4 ist schematisch ein solches System dargestellt, das aus mehreren Kammern 80, 82, 84, 86, 88, 90, 92 besteht. Das Kammersystem befindet sich in einem mit Inertgas gespülten Reaktionsraum (Reaktor). Das Substrat 30 wird in der Kammer auf Beschichtungstemperatur vorgeheizt. Die einzelnen Gastransportkammern 80 bis 100 bedeuten:

80 Gastransportkammer für die SiC-Beschichtung, 82 Gastransportkammer für die $p^+$-Si-Beschichtung, 84 Gastransportkammer für die Capping-Oxid-Beschichtung, 86 Kristallisationskammer, 88 Gastransportkammer für die Oxidentfernung, 90 Gastransportkammer für die $p^+$-Si-Beschichtung (Epitaxie) und 100 Gastransportkammer für die $n^+$-Si-Beschichtung (Diffusion oder Epitaxie).

Das fertig mit dem Halbleiterschichtsystem beschichtete Substrat 96 kann anschließend zur Weiterverarbeitung aus der Kammer über die Schleuse entnommen werden. Mit Hilfe dieser Anordnung kann innerhalb einer einzigen mit Inertgas gespülten Kammer ein für die Abscheidung des gesamten Halbleitersystems im Durchlaufbetrieb geeignetes System gebaut werden.

**Patentansprüche**

1. Verfahren und eine Vorrichtung zum Beschichten und/oder Behandeln einer Fläche eines Substrats durch Beaufschlagen dieser mit einem Gas mit für die Beschichtung erforderlichen schichtbildenden Teilchen, die auf der Fläche abgeschieden werden und/oder mit dieser reagieren,
**dadurch gekennzeichnet,**
**dass** das Gas in Teilströme aufgeteilt wird, die in Bezug auf ihre Teilchenkonzentration und/oder Verweildauer auf der Fläche und/oder unmittelbar im Gebiet der Fläche und/oder in unmittelbarer Nähe der Fläche des Substrats derart eingestellt werden, dass pro Flächeneinheit pro Zeiteinheit gleiche Mengen an Teilchen abgeschieden werden und/oder reagieren.

2. Verfahren nach Anspruch 1,

**dadurch gekennzeichnet,**
**dass** die Verweildauer durch Relativbewegung und/oder -geschwindigkeit zwischen der Fläche und die Teilströme abgebenden Quellen eingestellt wird und/oder dass die Quellen derart auf die Fläche ausgerichtet werden, dass die Teilströme vertikal oder im Wesentlichen vertikal aufsteigend auf die Fläche auftreffen, und/oder dass die Teilströme über mehrere Quellen an die Fläche abgegeben werden, zwischen denen sich Senken für mit der Fläche reagiertes und/oder das Substrat beaufschlagtes Gas befinden, wobei insbesondere das Substrat von seiner gasabgewandten Fläche her beheizt wird.

3. Verfahren nach Anspruch 1 oder 2,
**dadurch gekennzeichnet,**
**dass** die Quellen und/oder Senken gleichmäßig über die Fläche verteilt angeordnet werden und/oder dass die Quellen und/oder Senken gleichmäßig verteilt über einen Bereich angeordnet werden, der zumindest gleich vertikaler Projektion der Fläche des Substrates ist.

4. Verfahren nach zumindest einem der vorhergehenden Ansprüche,
**dadurch gekennzeichnet,**
**dass** zur Entfernung einer Oxidschicht wie Siliziumoxidschicht ein $H_2O$/HF-Gemisch über die Oxidschicht bei einer Temperatur T mit Raumtemperatur $\leq$ T $\leq$ 300 °C, insbesondere 50 °C $\leq$ T $\leq$ 100 °C geleitet wird.

5. Vorrichtung zum Beschichten und/oder Behandeln einer Fläche eines Substrates, insbesondere im CVD-Verfahren, durch Beaufschlagen dieser mit einem Gas mit für die Beschichtung erforderlichen schichtbildenden Teilchen, umfassend mehrere das Gas abgebende Quellen sowie mit dem Substrat reagiertes bzw. dieses beaufschlagtes Gas abführende Senken,
**dadurch gekennzeichnet,**
**dass** die Fläche (32) des Substrates (30) oberhalb der Quellen (14, 16, 18, 20, 46, 48, 50, 74, 76) und der Senken (22, 24, 26, 28, 52, 54, 62) angeordnet ist und dass zumindest die Quellen gleichmäßig auf einem Bereich angeordnet sind, der durch vertikale Projektion der Fläche des Substrates vorgegeben ist.

6. Vorrichtung nach Anspruch 5,
**dadurch gekennzeichnet,**
**dass** die Senken (22, 24, 26, 28, 52, 54) gleichmäßig verteilt auf durch die vertikale Projektion (34) des Substrates umgebenen Bereich verteilt und/oder gleichmäßig verteilt zwischen den Quellen (14, 16, 18, 20 46, 48, 50) angeordnet sind und/oder dass die Quellen (14, 16, 18, 20, 46, 48, 50, 74, 76) und die Senken (22, 24, 26, 28, 52, 54, 62) ein Gasverteilungssystem (12) bilden, dessen flächige Erstreckung zumindest gleich oder im Wesentlichen zumindest gleich der Fläche 34 des Substrates (30) ist.

7. Vorrichtung nach zumindest einem der Ansprüche 5 und 6,
   **dadurch gekennzeichnet,**
   **dass** die Quellen (14, 16, 18, 20) Öffnungen wie Schlitze und/oder Düsen aufweisen, über die das Gas auf die Fläche (34) des Substrats (30) zuführbar ist, wobei insbesondere die Quellen bzw. Austrittsöffnungen wie die Schlitze und/oder die Düsen in einer ersten parallel zu der Fläche des Substrats angeordneten Ebene verlaufen.

8. Vorrichtung nach zumindest einem der Ansprüche 5 bis 7,
   **dadurch gekennzeichnet,**
   **dass** die Senken (22, 24, 26, 28) in einer zweiten parallel zu der Fläche (34) des Substrats verlaufenden Ebene angeordnet sind, wobei insbesondere die erste und die zweite Ebene beabstandet zueinander sind, vorzugsweise die erste Ebene flächennäher als die zweite Ebene verläuft.

9. Vorrichtung nach zumindest einem der Ansprüche 5 bis 8,
   **dadurch gekennzeichnet,**
   **dass** die Quellen (14, 16, 18, 20 74, 76) Öffnungen wie Schlitze und/oder Düsen eines homogen verteiltes Gas enthaltenden Raumes (58) sind und/oder dass der Raum mehrere parallel zueinander verlaufende Gasverteilerrohre (46, 48, 50) umfasst und/oder dass mehrere Quellen bzw. die Düsen bzw. die Öffnungen und/oder die Schlitze entlang einer Geraden verlaufen, wobei mehrere Geraden parallel zueinander verlaufen.

10. Vorrichtung nach zumindest einem der Ansprüche 5 bis 9,
    **dadurch gekennzeichnet,**
    **dass** das Gasverteilungssystem (46, 48, 50, 52, 54) innerhalb eines Reaktionsraumes angeordnet ist, der von der Fläche (34) des Substrates (30) verschließbar bzw. begrenzt ist, wobei insbesondere das Substrat über Führungen (70, 72) dem Reaktionsraum (56) zuführbar bzw. auf diesem ausrichtbar ist.

11. Vorrichtung nach zumindest einem der Ansprüche 5 bis 10,
    **dadurch gekennzeichnet,**
    **dass** auf der dem Gasverteilungssystem abgewandten Fläche (42) des Substrates (30) eine Wärmequelle angeordnet ist.

12. Vorrichtung nach zumindest einem der Ansprüche 5 bis 11,
    **dadurch gekennzeichnet,**
    **dass** mehrere Reaktionsräume (80, 82, 84, 86, 88, 90, 92) in einer gegebenenfalls von einem Inertgas durchströmbaren Kammeranlage (78) angeordnet sind, wobei insbesondere jeder Reaktionsraum nacheinander von dem Substrat (30) bzw. dessen Fläche (34) verschließbar ist, und/oder dass die in der Kammeranlage angeordneten Reaktionsräume mit unterschiedlichen Gasen beaufschlagbar sind.

13. Vorrichtung nach zumindest einem der Ansprüche 5 bis 12,
    **dadurch gekennzeichnet,**
    **dass** die Kammeranlage (78) eine Durchlaufanlage ist, deren Reaktionsräume (80, 82, 84, 86, 88, 90, 92) zum sukzessiven Beschichten bzw. Behandeln der Fläche (34) des Substrates (30) nacheinander mit dem Substrat bzw. deren Fläche verschließbar sind.

Fig. 1

EP 1 143 034 A1

Fig. 2

Fig. 3

Fig. 4

EP 1 143 034 A1

## EUROPÄISCHER RECHERCHENBERICHT

**Europäisches Patentamt**

Nummer der Anmeldung

EP 01 10 8251

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 4 389 973 A (LINDFORS SVEN G ET AL) 28. Juni 1983 (1983-06-28) | 5-9 | C23C16/44 C23C16/455 C30B25/14 |
| Y | * Spalte 6, Zeile 12 - Zeile 24; Abbildungen 13,14 * | 12,13 | |
| X | PATENT ABSTRACTS OF JAPAN vol. 2000, no. 04, 31. August 2000 (2000-08-31) & JP 2000 012471 A (AGENCY OF IND SCIENCE &AMP;TECHNOL; ANELVA CORP; KANEGAFUCHI CHEM IND), 14. Januar 2000 (2000-01-14) | 1-3 | |
| Y | * Zusammenfassung * | 4 | |
| P,X | & US 6 189 485 A (MATSUDA ET AL) 20. Februar 2001 (2001-02-20) * Spalte 10, Zeile 5 - Zeile 31; Abbildung 10 * | 1-3 | |
| X | US 5 487 785 A (FUKASAWA TAKAYUKI ET AL) 30. Januar 1996 (1996-01-30) * Spalte 10, Zeile 58 - Spalte 11, Zeile 37; Abbildungen 7,8 * | 1-3 | |
| X | US 3 916 822 A (ROBINSON MCDONALD) 4. November 1975 (1975-11-04) * das ganze Dokument * | 1-3 | RECHERCHIERTE SACHGEBIETE (Int.Cl.7) C23C C30B |
| X | PATENT ABSTRACTS OF JAPAN vol. 011, no. 232 (C-437), 29. Juli 1987 (1987-07-29) & JP 62 044574 A (FUJITSU LTD), 26. Februar 1987 (1987-02-26) * Zusammenfassung * | 5,10,11 | |

-/--

Der vorliegende Recherchenbericht wurde für alle Patentansprüche erstellt

| Recherchenort | Abschlußdatum der Recherche | Prüfer |
|---|---|---|
| DEN HAAG | 19. Juli 2001 | Ekhult, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie,übereinstimmendes Dokument

EPO FORM 1503 03 82 (P04C03)

Europäisches Patentamt

# EUROPÄISCHER RECHERCHENBERICHT

Nummer der Anmeldung

EP 01 10 8251

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y | PATENT ABSTRACTS OF JAPAN<br>vol. 1998, no. 01,<br>30. Januar 1998 (1998-01-30)<br>& JP 09 256162 A (CANON INC),<br>30. September 1997 (1997-09-30)<br>* Zusammenfassung *<br>& US 6 113 732 A (YOSHIDA)<br>5. September 2000 (2000-09-05)<br>* Spalte 2, Zeile 17 - Spalte 3, Zeile 43;<br>Abbildung 8 *<br>* Spalte 6, Zeile 49 - Zeile 63; Abbildung<br>1 * | 12,13 | |
| Y | EP 0 782 195 A (FUJITSU LTD)<br>2. Juli 1997 (1997-07-02)<br>* Spalte 20, Zeile 38 - Zeile 51 * | 4 | |
| A | PATENT ABSTRACTS OF JAPAN<br>vol. 010, no. 217 (E-423),<br>29. Juli 1986 (1986-07-29)<br>& JP 61 054616 A (FUJITSU LTD),<br>18. März 1986 (1986-03-18)<br>* Zusammenfassung * | 6 | RECHERCHIERTE SACHGEBIETE (Int.Cl.7) |
| A | PATENT ABSTRACTS OF JAPAN<br>vol. 013, no. 423 (C-638),<br>20. September 1989 (1989-09-20)<br>& JP 01 162772 A (FUJITSU LTD),<br>27. Juni 1989 (1989-06-27)<br>* Zusammenfassung * | 8 | |
| A | PATENT ABSTRACTS OF JAPAN<br>vol. 1995, no. 11,<br>26. Dezember 1995 (1995-12-26)<br>& JP 07 221071 A (NEC KYUSHU LTD),<br>18. August 1995 (1995-08-18)<br>* Zusammenfassung * | 4 | |

Der vorliegende Recherchenbericht wurde für alle Patentansprüche erstellt

| Recherchenort | Abschlußdatum der Recherche | Prüfer |
|---|---|---|
| DEN HAAG | 19. Juli 2001 | Ekhult, H |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 01 10 8251

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-07-2001

| Im Recherchenbericht angeführtes Patentdokument | Datum der Veröffentlichung | Mitglied(er) der Patentfamilie | Datum der Veröffentlichung |
|---|---|---|---|
| US 4389973 A | 28-06-1983 | KEINE | |
| JP 2000012471 A | 14-01-2000 | US 6189485 B | 20-02-2001 |
| US 5487785 A | 30-01-1996 | JP 6283470 A | 07-10-1994 |
| | | JP 3081885 B | 28-08-2000 |
| | | JP 6283471 A | 07-10-1994 |
| | | KR 267959 B | 01-11-2000 |
| | | KR 267960 B | 15-09-2000 |
| US 3916822 A | 04-11-1975 | KEINE | |
| JP 62044574 1 A | | KEINE | |
| JP 09256162 1 A | | KEINE | |
| EP 0782195 A | 02-07-1997 | JP 2827181 B | 18-11-1998 |
| | | JP 5029569 A | 05-02-1993 |
| | | JP 5235292 A | 10-09-1993 |
| | | JP 3044861 B | 22-05-2000 |
| | | JP 5082750 A | 02-04-1993 |
| | | DE 69230156 D | 18-11-1999 |
| | | DE 69230156 T | 25-05-2000 |
| | | EP 0528183 A | 24-02-1993 |
| | | KR 9605243 B | 23-04-1996 |
| | | US 5661340 A | 26-08-1997 |
| JP 61054616 1 A | | KEINE | |
| JP 01162772 1 A | | KEINE | |
| JP 07221071 1 A | | KEINE | |

EPO FORM P0461

Für nähere Einzelheiten zu diesem Anhang : siehe Amtsblatt des Europäischen Patentamts, Nr.12/82